# EUROPÄISCHE PATENTSCHRIFT

(11) **EP 4 569 403 B1**
(45) Veröffentlichungstag und Bekanntmachung des Hinweises auf die Patenterteilung: **17.12.2025**
(21) Anmeldenummer: 24787427.4
(22) Anmeldetag: 08.10.2024
(51) Int. Cl.: G06F 3/04886, G06F 3/048, H03K 17/965, G06F 3/02, G06F 3/023, H01H 13/702, H01H 3/02

(54) **TASTENFELD**
KEYPAD
CLAVIER

(30) Priorität: 10.10.2023 DE 102023127590
(43) Veröffentlichungstag der Anmeldung: 18.06.2025
(73) Patentinhaber: Gebrüder Frei GmbH & Co. KG, 72461 Albstadt-Onstmettingen (DE)
(72) Erfinder: FREI, Thomas, 72458 Albstadt (DE); DUFT, Benjamin, 72459 Albstadt (DE); BAUER, Philipp, 72379 Hechingen (DE)
(74) Vertreter: Patentanwälte Ruff, Wilhelm, Beier, Dauster & Partner mbB
(86) Internationale Anmeldenummer: PCT/EP2024/078225
(87) Internationale Veröffentlichungsnummer: WO 2025/078343

(56) Entgegenhaltungen:
- US-B2- 11 720 176

## Beschreibung

Die Erfindung betrifft ein Tastenfeld für eine Bedieneinheit einer Sicherheitsanwendungen mit mindestens einer Taste, eine Bedieneinheit mit einem Tastenfeld und die Verwendung eines Tastenfelds in einer Bedieneinheit.

Als Taste wird im Zusammenhang mit der Anmeldung ein mechanisch oder manuell durch Berühren oder Drücken betätigbares Betätigungselement bezeichnet. Die Taste ist je nach Anwendungsfall als Tastschalter, insbesondere als Schließer oder Öffner, welcher nach einem Wegfall einer Berührung oder einwirkenden Kraft selbsttätig in einen Ausgangszustand zurückkehrt, oder als Wechselschalter, welcher nach einer Betätigung in einem geänderten Schaltzustand verbleibt, gestaltet. Als Tastenfeld wird eine Einheit umfassend mindestens eine Taste bezeichnet.

Aus US 11,720.176 B2 ist eine tragbare Rechnereinrichtung mit einer Tastatur bekannt, wobei es sich bei der Tastatur um eine virtuelle Tastatur handeln kann. Handelt es sich bei der Tastatur um eine virtuelle Tastatur, kann die Rechnereinrichtung ein Display unterhalb eines Gehäuses aufweisen, um Bilder der Tasten zu erzeugen.

Für Bedieneinheiten von Sicherheitsanwendungen ist es bekannt, Relais, Tastschalter und/oder Wechselschalter, mit zwei oder mehr elektromechanischen Kontakten zu realisieren. Um ein Risiko einer fehlerhaften Auslösung durch einen Defekt eines Kontakts zu vermeiden, beispielsweise ein fehlendes Öffnen durch ein sogenanntes Verschweißen eines Kontakts, sind die Kontakte mechanisch gekoppelt. Derartige mechanisch gekoppelte Kontakte werden auch als zwangsgeführte Kontakte bezeichnet.

Aufgrund ihres elektromechanischen Aufbaus benötigen derartige Tasten mit zwangsgeführten Kontakten einen relativ großen Bauraum und haben oft eine begrenzte maximale Anzahl an Schaltzyklen. Um den Ausfall eines Kontakts zu erkennen, müssen bei redundant ausgelegten Tasten die Kontakte außerdem überwacht und diagnostiziert werden.

Aus DE 102020212536 A1 ist eine Taste für Sicherheitsanwendungen, umfassend eine Bedienfläche, einen ersten berührungssensitiven Sensor und einen zweiten berührungssensitiven Sensor bekannt, wobei der erste berührungssensitive Sensor und der zweite berührungssensitive Sensor derart angeordnet sind, dass eine Berührung der Bedienfläche und/oder ein Krafteintrag an der Bedienfläche mit einem menschlichen Finger oder einem Eingabeelement mittels des ersten berührungssensitiven Sensors und mittels des zweiten berührungssensitiven Sensors gleichzeitig erfassbar ist.

Aus DE 10 2009 036 860 A1 ist eine Bedieneinheit umfassend mindestens einen Taster mit einem beweglichen Tastenelement, mindestens ein Display sowie mindestens ein transparentes, berührungsempfindliches Eingabefeld bekannt, wobei das mindestens eine Eingabefeld mit dem Tastenelement derart verbunden ist, dass bei Betätigung des mindestens einen Eingabefeldes gleichzeitig der Taster betätigbar ist, und wobei das mindestens eine Display durch das mindestens eine Eingabefeld hindurch oder durch das mindestens eine Eingabefeld und das Tastenelement hindurch sichtbar ist.

### AUFGABE UND LÖSUNG

Es ist eine Aufgabe der Erfindung, ein Tastenfeld für eine Bedieneinheit einer Sicherheitsanwendung zu schaffen, welches für eine intuitive Nutzung konfigurierbar ist. Es sind weitere Aufgaben, eine Bedieneinheit mit einem Tastenfeld und die Verwendung eines Tastenfelds in einer Bedieneinheit zu schaffen.

Gemäß einem ersten Aspekt wird ein Tastenfeld für eine Bedieneinheit einer Sicherheitsanwendungen geschaffen, umfassend mindestens zwei Tasten, vorzugsweise mehr als zwei Tasten, mit jeweils einer Tastkappe, einen ersten berührungssensitiven Sensor und einen zweiten Sensor, wobei der erste berührungssensitive Sensor und der zweite Sensor derart angeordnet sind, dass eine Berührung der Tastkappe von einer der Tasten und/oder ein Krafteintrag an dieser Tastkappe mit einem menschlichen Finger oder einem Eingabeelement mittels des ersten berührungssensitiven Sensors und mittels des zweiten Sensors gleichzeitig erfassbar ist, wobei die Tastkappen zumindest bereichsweise transparent sind und wobei unterhalb der Tastkappen eine Display-Einheit angeordnet ist, wobei die Display-Einheit eine den Tastkappen gemeinsame Display-Oberfläche aufweist, und wobei eine Überwachungseinrichtung vorgesehen ist, die eingerichtet ist, um eine Anzeige an der Display-Einheit zu erfassen.

Die Begriffe "ein", "eine" etc. werden im Zusammenhang mit der Anmeldung lediglich als unbestimmte Artikel und nicht als Zählwörter verwendet.

Als Display-Einheit wird im Zusammenhang mit der Anmeldung eine elektrisch angesteuerte Anzeigeeinheit zur optischen Signalisierung von veränderlichen Informationen wie Bildern oder Zeichen und/oder deren Farben bezeichnet. Die Display-Einheit erlaubt es, ein Erscheinungsbild der Tasten anzupassen, sodass die Tasten jeweils ein je nach Anwendungsfall durch den Nutzer und/oder in einer Konfiguration festlegbares Erscheinungsbild aufweisen.

Als "unterhalb der Tastkappe" wird eine Anordnung an einer Seite gegenüberliegend zu einer Betätigungsseite der Tastkappe bezeichnet. Je nach Anwendungsfall kann die Display-Einheit im Raum links, rechts und/oder auch oberhalb der Tastkappe angeordnet sein.

Mindestens einer der zwei oder mehr Sensoren ist als berührungssensitiver Sensor gestaltet. Als berührungssensitive Sensoren werden im Zusammenhang mit der Anmeldung elektronische Systeme zur Erfassung einer Berührung der Tastkappe und/oder eines Krafteintrags an der Tastkappe mit einem menschlichen Finger oder einem Eingabeelement bezeichnet. Derartige Sensoren werden auch als Touchsensoren bezeichnet.

Für die Erfassung einer Berührung und/oder eines Krafteintrags sind verschiedene Technologien bekannt. Die Sensoren sind in einer Ausgestaltung als Kraftsensoren gestaltet, mittels welchen auf die Tastkappe einwirkende Kräfte erfassbar sind. Die einwirkenden Kräfte bewirken dabei in einer Ausgestaltung eine Bewegung der Tastkappe. In anderen Ausgestaltungen sind die Sensoren geeignet, um eine Berührung der Tastkappen auch ohne auf diese für eine Verstellbewegung einwirkende Kräfte zu erfassen.

In Ausgestaltungen sind beide Sensoren als berührungssensitive Sensoren gestaltet. Die Sensoren verwenden dabei in Ausgestaltungen unterschiedliche Technologien.

In anderen Ausgestaltungen ist der zweite Sensor als optischer Sensor oder als anderer Sensor, mittels welchem eine Betätigung der Taste erfassbar ist, gestaltet.

Signale der zwei Sensoren sind mittels einer geeigneten Auswerteeinheit, beispielsweise jedoch nicht ausschließlich mit einer Auswerteeinheit gemäß DE 102020212536 A1, auswertbar, um Anforderungen an eine Sicherheitsanwendung zu genügen.

Das Tastenfeld weist in Ausgestaltungen ausschließlich Tasten auf, deren Betätigung durch einen ersten berührungssensitiven und einen zweiten Sensor erfassbar ist. In anderen Ausgestaltungen sind an dem Tastenfeld weitere Tasten vorgesehen.

In Ausgestaltungen ist die Überwachungseinrichtung eingerichtet, un eine Anzeige an einem unbelegten Bereich der Display-Oberfläche zu erfassen. Als unbelegte Bereiche werden dabei Bereiche der Display-Oberfläche bezeichnet, welchen keine Tastkappen zugeordnet sind. Die Überwachungseinrichtung ist insbesondere gestaltet, um ein sogenanntes "Einfrieren" der Display-Einheit zu erfassen, d.h. einen Zustand, in welchem trotz Betätigen der Tasten keine Anpassung der Display-Einheit an die Betätigung erfolgt. In Ausgestaltungen wird zu diesem Zweck mittels der Überwachungseinrichtung eine Anzeige an der Display-Einheit, insbesondere an einem unbelegten Bereich der Display-Oberfläche, optisch erfasst und ein entsprechendes Signal an eine Steuereinrichtung gesendet. Mittels der Steuereinrichtung ist eine Auswertung des Signals möglich, um festzustellen, ob bei erfasster Betätigung einer Taste eine zugehörige Anpassung einer Anzeige an der Display-Einheit erfolgt ist.

In einer Ausgestaltung ist eine Steuereinrichtung vorgesehen, wobei eine durch Betätigen der Tasten durchzuführende Funktion veränderbar ist und mittels der Steuereinrichtung die den Tasten zugeordnete Anzeige an der Display-Einheit an die durchzuführende Funktion anpassbar ist. In anderen Worten ist es möglich, situativ eine Taste mit verschiedenen Funktionen zu belegen, wobei einem Nutzer eine veränderte Belegung der Taste optisch signalisierbar ist. Durch eine situativ angepasste Belegung von Tasten ist es möglich, eine Anzahl der Tasten in einem Tastenfeld zu minimieren. Insbesondere für Sicherheitsanwendungen ist jedoch eine Fehlbetätigung einer Taste zu vermeiden. Durch Anpassung der Anzeige an der Display-Einheit an die durchzuführende Funktion ist eine intuitive Betätigung und/oder eine durch die Anzeige unterstützte Betätigung möglich. In einer Ausgestaltung erfolgt eine Veränderung der durch Betätigen der Taste durchzuführende Funktion ebenfalls mittels der Steuereinrichtung. Die Steuereinrichtung ist dabei je nach Anwendungsfall auf verschiedene Einheiten verteilt oder als eine Einheit gestaltet.

Das Tastenfeld umfasst in einer Ausgestaltung einen Wahlschalter, insbesondere ein Drehrad (auch als Drehschalter bezeichnet) oder ein Drehdrückrad (auch als Dreh-/Drückknopf bezeichnet), weiter insbesondere ein Leucht-Drehrad oder ein Leucht-Drehdrückrad, wobei der Wahlschalter mit der Steuereinrichtung gekoppelt ist, sodass durch Betätigung des Wahlschalters die durch Betätigen der Tasten durchzuführende Funktion veränderbar ist.

In einer Ausgestaltung ist dabei vorgesehen, dass mittels des Wahlschalters eine Einrichtung und/oder Komponente der Sicherheitseinrichtung anwählbar ist, wobei die durch Betätigen einer der Tasten durchzuführende Funktion entsprechend der angewählten Einrichtung und/oder Komponente veränderbar ist. Für eine intuitive Nutzerführung ist dabei in einer Ausgestaltung eine Farbführung vorgesehen, wobei verschiedenen Einrichtungen und/oder Komponenten der Sicherheitseinrichtung unterschiedliche Farben zugewiesen werden können. In Ausgestaltungen weist der Wahlschalter ein Leuchtmittel auf, beispielsweise ist der Wahlschaler als Leucht-Drehrad oder Leucht-Drehdrückrad gestaltet, wobei die Steuereinrichtung eingerichtet ist, um den Wahlschalter und die Taste entsprechend einer ausgewählten Einrichtung und/oder Komponente mit einer zugewiesenen Farbe zu kennzeichnen.

In einer Ausgestaltung ist mittels der Steuereinrichtung die den Tasten zugeordnete Anzeige an der Display-Einheit entsprechend einem Menü veränderbar. Je nach Ausgestaltung sind dabei alle oder einzelne der Tasten situativ angepasst belegbar, sodass eine Anzahl der Tasten in dem Tastenfeld reduziert werden kann und/oder einem Nutzer je nach Situation und/oder Vorauswahl lediglich eine definierte Auswahl an Funktionen zur Verfügung steht. In Ausgestaltungen ist/sind dabei der erste Sensor und/oder der zweite Sensor mit der Steuereinrichtung gekoppelt, sodass durch Betätigung einer der Taste ein Aufrufen oder Schließen eines Untermenüs bewirkbar ist. Die Taste für ein Aufrufen eines Untermenüs ist dabei in Ausgestaltung eine andere Taste als die Tasten zum Schließen eines Untermenüs. In anderen Ausgestaltungen kann eine Tastenbelegung zum Aufrufen und Schließen zumindest für bestimme Untermenüs einheitlich erfolgen. In wieder anderen Ausgestaltungen ist ein alternativ oder zusätzlich der Wahlschalter vorgesehen. Der Wahlschalter ist mit der Steuereinrichtung gekoppelt, sodass durch Betätigung des Wahlschalters ein Aufrufen eines Menüs, insbesondere eines einer Einrichtung und/oder Komponente der Sicherheitseinrichtung zugeordneten Menüs, bewirkbar ist, wobei einzelnen, mehreren oder allen Tasten jeweils eine durchzuführende Funktion entsprechend eines mittels des Wahlschalters angewählten Menüs zugewiesen ist. Dabei ist in einer Ausgestaltung eine Farbführung vorgesehen, wobei verschiedenen Komponenten und/oder Einrichtungen der Sicherheitsanwendung unterschiedliche Farben zugewiesen sind. Mit Aufrufen eines einer Komponente und/oder Einrichtung zugeordneten Menüs durch Betätigung des Wahlschalters ist dabei in Ausgestaltungen vorgesehen, dass der Wahlschalter und einzelne, mehrere oder alle Tasten entsprechend farblich gekennzeichnet werden.

Wie oben ausgeführt, sind die Sensoren je nach Anwendungsfall geeignet wählbar.

In einer Ausgestaltung sind der erste berührungssensitive Sensor und die Display-Einheit zusammen als berührungssensitive Display-Einheit gestaltet, insbesondere als resistive berührungssensitive Display-Einheit. Der erste berührungssensitive Sensor nutzt dabei insbesondere eine als Glas oder Folie gestaltete Benutzeroberfläche der Display-Einheit. Derartige berührungssensitive Display-Einheit werden auch als Touchscreen bezeichnet.

Alternativ ist in Ausgestaltung der erste berührungssensitive Sensor als Schalterfolie umfassend eine Trennschicht und zwei mittels der Trennschicht im Ruhezustand getrennte leitende Schichten gestaltet, wobei die Display-Einheit unterhalb der Schalterfolie angeordnet ist.

Alternativ oder zusätzlich ist zweite Sensor ebenfalls als berührungssensitiver Sensor gestaltet, wobei der zweite berührungssensitive Sensor als Schalterfolie umfassend eine Trennschicht und zwei mittels der Trennschicht im Ruhezustand getrennte leitende Schichten, insbesondere zwei Kohleschichten, Schichten mit Leitpaste. metallisierte Schichten und/oder Metallschichten, gestaltet, wobei die Display-Einheit, insbesondere die berührungssensitive Display-Einheit, unterhalb der Schalterfolie angeordnet ist. Die Schalterfolie ist vorzugsweise derart gestaltet, dass bei mehreren Tasten auch Identifikation der Taste, welche betätigt wurde, möglich ist.

In einer Ausgestaltung ist eine elastisch verformbare Schicht, insbesondere eine Silikonschicht, vorgesehen ist, wobei die Tastkappe, bei mehreren Tasten die Tastkappen, in der elastisch verformbaren Schicht eingebettet ist/sind und aus einer Ruhestellung in eine Betätigungsstellung entgegen einwirkender Rückstellkräfte der elastisch verformbaren Schicht verstellbar ist/sind. Die Silikonschicht dient dabei in Ausgestaltungen auch dazu, das Tastenfeld vor Staub und Wasser zu schützen. Die Rückstellkräfte der elastisch verformbaren Schicht sind dabei in Ausgestaltungen ausreichend, um eine als Tastschalter gestaltete Taste, bei Wegfall einer Berührung oder einwirkenden Kraft in einen Ausgangszustand zurückzubringen. In anderen Ausgestaltungen sind zusätzliche Rückstellelemente vorgesehen.

In Ausgestaltungen sind unbelegte Bereiche der Display-Oberfläche durch die elastische verformbare Schicht maskiert. Die Schicht dient in anderen Worten einer Maskierung von Bereichen der Display-Oberfläche zwischen den einzelnen Tastkappen. Durch die Schicht entsteht so der Eindruck, einzelner, jeweils einer Tastkappe zugeordneter Display-Einheiten.

Die elastisch verformbare Schicht ist in Ausgestaltungen zumindest halbopak, insbesondere opak. Als "halbopak" wird hier einen Schicht bezeichnet, welche den größten Teil des Lichts reflektiert, aber einen kleinen Teil des Lichts durchlässt. Als "opak" wird eine Schicht bezeichnet, welche das gesamte Licht reflektiert und kein Licht durchlässt. Insbesondere bei einer Verwendung der unbelegten Bereich für eine Überwachung der Anzeige mit der Überwachungseinrichtung ist es dabei möglich, aufgrund der Maskierung der unbelegten Bereiche die Überwachung durchzuführen, ohne dass dies durch den Nutzer wahrnehmbar ist.

Das Tastenfeld umfasst in Ausgestaltungen eine Mehrzahl an Tasten mit jeweils einer Tastkappe, wobei eine Berührung einer Tastkappe der Mehrzahl an Tasten und/oder ein Krafteintrag an einer Tastkappe der Mehrzahl an Tasten mit einem menschlichen Finger oder einem Eingabeelement mittels des ersten berührungssensitiven Sensors und/oder mittels des zweiten Sensors lokalisierbar ist.

Gemäß einem zweiten Aspekt wird eine Bedieneinheit für eine mobile Maschine, wie beispielsweise eine Landmaschine, eine Baumaschine, ein Flurförderfahrzeug oder dergleichen, umfassend ein Tastenfeld geschaffen. Die Bedieneinheit ist dabei je nach Anwendungsfall geeignet gestaltbar. Die Bedieneinheit ist beispielsweise in ein Lenkrad, eine Armlehne oder ein Armaturenbrett integriert und/oder als mobile Bedieneinheit gestaltet.

Durch die Möglichkeit, die Anzeige an den Tasten situativ anzupassen, kann die Anzahl der Tasten dabei gegenüber herkömmlichen Bedieneinheiten reduziert werden, wobei eine intuitive Betätigung erhalten bleibt.

Gemäß einem dritten Aspekt wird eine Verwendung eines Tastenfelds mit einer zumindest bereichsweise transparenten Tastkappe und einer unterhalb der Tastkappe angeordneten Display-Einheit in einer Bedieneinheit für eine mobile Maschine, wie beispielsweise eine Landmaschine, eine Baumaschine, ein Flurförderfahrzeug, geschaffen. Das Tastenfeld umfasst zwei Sensoren, um Sicherheitsanforderungen derartige mobiler Maschinen zu genügen.

Eine durch Betätigen einer ausgewählten Taste durchzuführende Funktion kann dabei durch Gestaltung der Anzeige mit Farben, den Tasten zugeordneten Piktogrammen, den Tasten zugeordneten Zeichen oder ähnlichem optisch kenntlich gemacht werden.

In einer Ausgestaltung sieht die Verwendung vor, dass eine durch Betätigen der Taste durchzuführende Funktion veränderbar ist und eine der Taste zugeordnete Anzeige an der Display-Einheit an die durchzuführende Funktion angepasst wird.

In Ausgestaltungen umfasst das Tastenfeld mehrere Tasten, wobei eine den Tasten zugeordnete Anzeige an der Display-Einheit entsprechend einem Menü veränderbar ist.

Die Verwendung sieht in Ausgestaltungen vor, dass durch Betätigung einer der Tasten ein Aufrufen oder Schließen eines Untermenüs bewirkt wird.

Alternativ oder zusätzlich sieht die Verwendung in Ausgestaltungen vor, dass durch Betätigung eines Wahlschalters, der mit der Steuereinrichtung gekoppelt ist, insbesondere eines Drehrads oder eines Drehdrückrads, weiter insbesondere eines Leucht-Drehrads oder ein Leucht-Drehdrückrads, die durch Betätigen der Taste durchzuführende Funktion verändert wird. Dabei ist insbesondere bei Verwendung eines Tastenfelds mit mehreren Tasten vorgesehen, dass mittels des Wahlschalters ein für eine Komponente und/oder Einrichtung vorgesehenes Menü angewählt wird, wobei mit der Anwahl des Menüs einer, mehreren oder allen Tasten des Tastenfelds jeweils eine für die Komponente und/oder Einrichtung festgelegte Funktion zugewiesen wird. Für eine intuitive Erfassung einer angewählten Komponente und/oder Einrichtung ist dabei in einer Ausgestaltung der Komponente und/oder Einrichtung eine Farbe zugewiesen, wobei bei Anwahl der Komponente und/oder Einrichtung mittels des Wahlschalters der Wahlschalter und eine, mehrere oder alle Tasten des Tastenfelds mittels der zugewiesenen Farbe kenntlich gemacht werden.

### KURZBESCHREIBUNG DER ZEICHNUNGEN

Weitere Vorteile und Aspekte der Erfindung ergeben sich aus den Ansprüchen und aus der Beschreibung von Ausführungsbeispielen der Erfindung, die nachfolgend anhand der schematischen Figuren erläutert sind. Dabei zeigen:
- Fig. 1: ein Tastenfeld in einer Explosionsdarstellung und
- Fig. 2: eine an einer Armauflage angeordnete Bedieneinheit umfassend ein Tastenfeld in einer perspektivischen Darstellung.

### DETAILLIERTE BESCHREIBUNG DER AUSFÜHRUNGSBEISPIELE

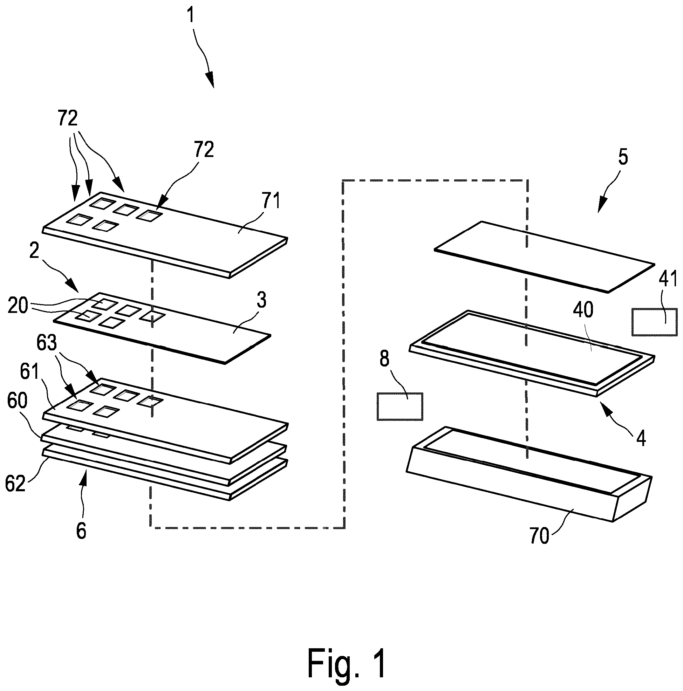

Fig. 1 zeigt schematisch in einer Explosionsdarstellung ein Tastenfeld 1 umfassend mehrere, in dem dargestellten Ausführungsbeispiel fünf Tasten 2 mit jeweils einer Tastkappe 20.

Die Tastkappen 20 sind gemeinsam in einer elastisch verformbaren Schicht 3 eingebettet und individuell aus einer Ruhestellung in eine Betätigungsstellung entgegen einwirkender Rückstellkräfte der elastisch verformbaren Schicht 3 verstellbar.

In Betätigungsrichtung betrachtet unterhalb der Tastkappen 20 sind eine Display-Einheit 4, ein erster berührungssensitiver Sensor 5 und ein zweiter, in dem dargestellten Ausführungsbeispiel ebenfalls berührungssensitiver Sensor 6 vorgesehen. Die elastisch verformbare Schicht 3, die Display-Einheit 4, der erste berührungssensitive Sensor 5 und der zweite Sensor 6 sind in einem Gehäuse umfassend einen Boden 70 und eine Deckplatte 71 angeordnet. Die Deckplatte 71 weist Aussparungen 72 für die Tastkappen 20 auf, sodass die Tastkappen 20 von einer Außenseite des Gehäuses für eine Betätigung zugänglich sind. Bei der elastisch verformbaren Schicht handelt es sich in Ausgestaltungen um eine Silikonschicht, welche auch einer Abdichtung des Gehäuses gegenüber eindringendem Staub und/oder Flüssigkeiten erlaubt.

Die Tastkappen 20 sind jeweils zumindest bereichsweise, vorzugsweise vollständig, transparent, sodass über die Tastenkappen 20 eine Anzeige an der darunterliegende Display-Einheit 4 sichtbar ist. Die Display-Einheit 4 weist eine den Tastkappen 20 gemeinsame, durchgängige Display-Oberfläche 40 auf. Die elastisch verformbare Schicht 3 maskiert unbelegte Bereiche der Display-Oberfläche 40, d.h. Bereiche der Display-Oberfläche 40 denen keine Tastkappen 20 zugeordnet sind. Die elastische Schicht 3 ist zu diesem Zweck in Ausgestaltungen opak, insbesondere schwarz eingefärbt.

Der erste berührungssensitive Sensor 5 und der zweite Sensor 6 sind derart angeordnet, dass eine Berührung einer der Tastkappen 20 und/oder ein Krafteintrag an einer der Tastkappen 20 mit einem menschlichen Finger oder einem Eingabeelement mittels des ersten berührungssensitiven Sensors 5 und mittels des zweiten Sensors 6 gleichzeitig erfassbar und lokalisierbar, d.h. der zugehörigen Taste 2 zuordenbar ist.

Der erste berührungssensitive Sensor 5 und die Display-Einheit 4 sind in Ausgestaltungen zusammen als berührungssensitive Display-Einheit gestaltet, wobei eine Oberfläche der Display-Einheit als Teil des ersten berührungssensitiven Sensors 5 genutzt wird.

In dem dargestellten Ausführungsbeispiel ist der zweite Sensor 6 ebenfalls als berührungssensitiver Sensor 6 gestaltet, wobei der zweite berührungssensitive Sensor 6 als Schalterfolie umfassend eine Trennschicht 60 und zwei mittels der Trennschicht 60 im Ruhezustand getrennte leitende Schichten 61, 62.

Die Display-Einheit 4, insbesondere die berührungssensitive Display-Einheit, ist in Betätigungsrichtung unterhalb des als Schalterfolie gestalteten zweiten berührungssensitiven Sensors 6 angeordnet. Um eine Sicht auf die Display-Einheit 4 zu erlauben, ist die Schalterfolie in Ausgestaltungen zumindest bereichsweise transparent. In anderen Ausgestaltungen weist die Schalterfolie wie dargestellt Aussparungen 63 auf. Für eine Betätigung der Schalterfolie, sodass die leitenden Schichten 61, 62 einander berühren, ist in Ausgestaltungen an einer der Display-Einheit 4 zugewandten Rückseite der Tastkappen 20 jeweils ein Stößel (nicht dargestellt) vorgesehen.

Das Tastenfeld umfasst weiter eine schematisch dargestellte Steuereinrichtung 8 für eine Ansteuerung der Display-Einheit 4.-

In Ausgestaltungen ist dabei eine den Tasten 2 zugeordnete Anzeige an der Display-Einheit 4 mittels der Steuereinrichtung 8 veränderbar.

Dabei ist insbesondere in Ausgestaltungen vorgesehen, dass mittels der Steuereinrichtung 8 eine durch Betätigen der Taste 2 durchzuführende Funktion veränderbar ist, wobei der Taste 2 zugeordnete Anzeige an der Display-Einheit 4 an die durchzuführende Funktion angepasst wird. Durch die Anpassung der Anzeige an die geänderte Funktion ist dem Nutzer die der Taste 2 zugeordnete Funktion auf einfache Weise signalisierbar.

In dem dargestellten Ausführungsbeispiel ist weiter eine Überwachungseinrichtung 41 vorgesehen, um eine Anzeige an der Display-Einheit 4, insbesondere an einem unbelegten und mittels der elastischen Schicht 3 maskieren Bereich der Display-Oberfläche 40, zu erfassen.

Für eine Überwachung ist dabei in Ausgestaltungen vorgesehen, dass eine Betätigung einer Taste 2 durch die Sensoren 5, 6 erfasst wird und die Steuereinrichtung 8 die Display-Einheit 4 zur Anzeige der Daten entsprechend der betätigten Taste 2 ansteuert. Dabei wird in dem unbelegten Bereich ein Kontrollsignal angezeigt, welches mittels der Überwachungseinrichtung 41 erfassbar ist, insbesondere optisch erfassbar. Die Überwachungseinrichtung 41 meldet ein erfasstes Signal an. Erst im Anschluss daran wird eine den Tasten 2 zugeordnete Funktion freigeschaltet.

Die Steuereinrichtung 8 und die Display-Einheit 4 sind dabei in Ausgestaltungen derart gestaltet, dass mittels der Steuereinrichtung 8 die den Tasten 2 zugeordnete Anzeige an der Display-Einheit 4 entsprechend einem Menü veränderbar ist.

Beispielsweise ist in einer Ausgestaltung vorgesehen, dass in einem Ausgangszustand ein Hauptmenü an dem Tastenfeld 1 dargestellt ist, wobei ein Nutzer durch Anwählen und Betätigen einer der Tasten 2 ein Untermenü auswählen kann. Mit Betätigung dieser Taste 2 ist dabei in Ausgestaltung die durch Betätigen der Tasten 2 jeweils durchzuführende Funktion entsprechend des ausgewählten Untermenüs veränderbar.

Dabei ist die den Tasten 2 zugeordnete Anzeige an der Display-Einheit 4 mittels der Steuereinrichtung 8 entsprechend des ausgewählten Untermenüs veränderbar.

In einer Ausgestaltung ist dabei vorgesehen, dass bei Auswählen eines Untermenüs die einer definierten Taste 2 zugeordnete Anzeige an der Display-Einheit 4 mittels der Steuereinrichtung 8 so veränderbar ist, dass diese als Taste 2 für ein Schließen des Untermenüs oder eine Rückkehr zu einem Hauptmenü erfassbar ist.

Das Tastenfeld 1 ist in einer Bedieneinheit für eine mobile Maschine, wie beispielsweise eine Landmaschine, eine Baumaschine, ein Flurförderfahrzeug, oder dergleichen integrierbar.

In Ausgestaltungen ist das Tastenfeld 1 beispielsweise in einer Bedieneinheit für eine mobile Maschine, wie beispielsweise eine Landmaschine, eine Baumaschine, ein Flurförderfahrzeug, oder dergleichen, mit mehreren Komponenten integriert, wobei eine Komponente durch Betätigung einer zugehörigen Taste 2 an einem Hauptmenü anwählbar. In diesem Hauptmenü ist die Display-Einheit 4 derart ansteuerbar, dass für die Komponenten an den Tasten 2 jeweils ein zugehöriges Piktogramm und/oder eine definierte Farbe angezeigt ist. Mit Betätigung einer der Tasten 2 und damit Auswahl der zugeordneten Komponente ist ein Untermenü aufrufbar, wobei alle oder einzelne der mittels der Tasten 2 durchzuführenden Funktionen verändert sind, und wobei die den Tasten 2 zugeordnete Anzeige an der Display-Einheit 4 mittels der Steuereinrichtung 8 entsprechend des ausgewählten Untermenüs verändert wird.

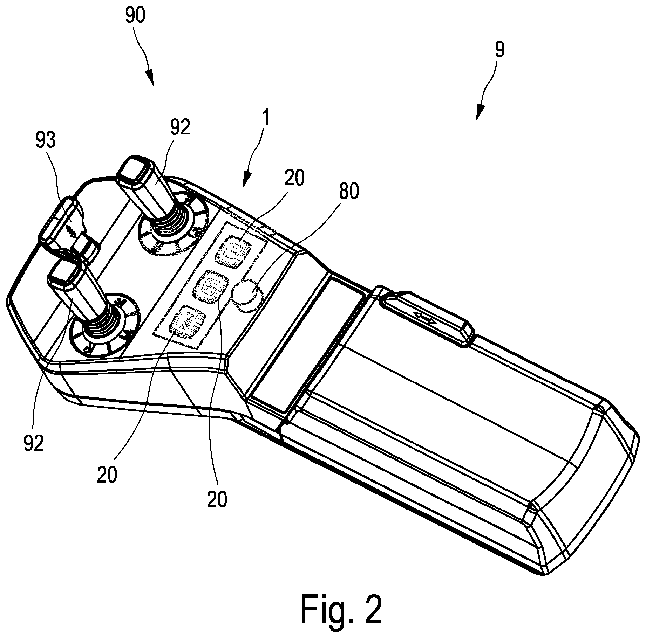

Fig. 2 zeigt schematisch in einer perspektivischen Darstellung eine an einer Armauflage 9 angeordnete Bedieneinheit 90 umfassend zwei Joysticks 92, einen Richtungsschalter 93 und ein Tastenfeld 1 mit drei Tasten 20. Die Armauflage 9 mit der Bedieneinheit 90 ist beispielsweise an einer mobilen Maschine wie einer Land- oder Baumaschine, einem Flurförderzeug sowie zahlreichen Industrieanwendungen einsetzbar.

Die Erfindung ist jedoch nicht auf die Verwendung eines Tastenfelds 1 einer an einer Armlehne 9 angeordneten Bedieneinheit 90 beschränkt. Vielmehr sind zahlreiche weitere Anwendungen denkbar.

Das in Fig. 2 dargestellte Tastenfeld 1 umfasst drei Tasten 2 sowie einen beispielsweise als Drehdrückrad gestalteten Wahlschalter 80. Der Wahlschalter 80 ist mit einer in Fig. 2 nicht dargestellten Steuereinrichtung 8 (vgl. Fig. 1) gekoppelt ist, sodass durch Betätigung des Wahlschalters 80 die durch Betätigen einer, mehrerer oder aller Tasten 2 jeweils durchzuführende Funktion veränderbar ist.

Die in Fig. 2 dargestellte Bedieneinheit 90 dient beispielsweise der Bedienung einer mobilen Maschine, wie beispielsweise einer Landmaschine, einer Baumaschine, einem Flurförderfahrzeug, oder dergleichen, mit mehreren Komponenten. Mittels des Wahlschalters 80 ist dabei in Ausgestaltungen ein Hauptmenü, ein Untermenü für eine der Komponenten und/oder Untermenü für eine weitere Einrichtung der Maschine, wie beispielsweise eine Klimaeinrichtung, anwählbar. Mit Anwahl eines Menüs werden je nach Ausgestaltung und/oder Menü alle oder einzelne der mittels der Tasten 2 durchzuführenden Funktionen verändert, wobei die den Tasten 2 zugeordnete Anzeige an der Display-Einheit 4 mittels der Steuereinrichtung 8 entsprechend des ausgewählten Menüs verändert wird.

## Patentansprüche

1. Tastenfeld für eine Bedieneinheit einer Sicherheitsanwendungen umfassend eine Mehrzahl an Tasten (2) mit jeweils einer Tastkappe (20), einen ersten berührungssensitiven Sensor (5) und einen zweiten Sensor (6), wobei der erste berührungssensitive Sensor (5) und der zweite Sensor (6) derart angeordnet sind, dass eine Berührung der Tastkappe (20) einer der Mehrzahl an Tasten (2) und/oder ein Krafteintrag an dieser Tastkappe (20) mit einem menschlichen Finger oder einem Eingabeelement mittels des ersten berührungssensitiven Sensors (5) und mittels des zweiten Sensors (6) gleichzeitig erfassbar ist, wobei die Tastkappen (20) zumindest bereichsweise transparent ist und unterhalb der Tastkappen (20) eine Display-Einheit angeordnet ist, wobei die Display-Einheit (4) eine den Tastkappen (20) gemeinsame Display-Oberfläche (40) aufweist, **dadurch gekennzeichnet, dass** eine Überwachungseinrichtung (41) vorgesehen ist, die eingerichtet ist, um eine Anzeige an der Display-Einheit (4) zu erfassen.

2. Tastenfeld nach Anspruch 1, **dadurch gekennzeichnet, dass** die Überwachungseinrichtung (41) eingerichtet ist, um eine Anzeige an einem unbelegten Bereich der Display-Oberfläche (40), zu erfassen.

3. Tastenfeld nach Anspruch 1 oder 2, **dadurch gekennzeichnet, dass** eine Steuereinrichtung (8) vorgesehen ist, wobei eine durch Betätigen der Tasten (2) durchzuführende Funktion veränderbar ist und mittels der Steuereinrichtung (6) eine den Taste (2) zugeordnete Anzeige an der Display-Einheit (4) an die durchzuführende Funktion anpassbar ist.

4. Tastenfeld nach Anspruch 3, **dadurch gekennzeichnet, dass** ein Wahlschalter (80) vorgesehen ist, insbesondere ein Drehrad oder ein Drehdrückrad, weiter insbesondere ein Leucht-Drehrad oder ein Leucht-Drehdrückrad, wobei der Wahlschalter (80) mit der Steuereinrichtung (8) gekoppelt ist, sodass durch Betätigung des Wahlschalters (80) die durch Betätigen der Tasten (2) durchzuführende Funktion veränderbar ist.

5. Tastenfeld nach Anspruch 2, 3 oder 4, **dadurch gekennzeichnet, dass** mittels der Steuereinrichtung (8) die den Tasten (2) zugeordnete Anzeige an der Display-Einheit (4) entsprechend einem Menü veränderbar ist, wobei insbesondere der erste Sensor (5) und/oder der zweite Sensor (6) mit der Steuereinrichtung (8) gekoppelt ist/sind, sodass durch Betätigung einer der Taste (2) ein Aufrufen oder Schließen eines Untermenüs bewirkbar ist.

6. Tastenfeld nach einem der Ansprüche 1 bis 5, **dadurch gekennzeichnet, dass** der erste berührungssensitive Sensor (5) und die Display-Einheit (4) zusammen als berührungssensitive Display-Einheit gestaltet sind, insbesondere als resistive berührungssensitive Display-Einheit.

7. Tastenfeld nach einem der Ansprüche 1 bis 6, **dadurch gekennzeichnet, dass** der zweite Sensor (6) als berührungssensitiver Sensor (6) gestaltet ist, wobei insbesondere der zweite Sensor (6) als Schalterfolie umfassend eine Trennschicht (60) und zwei mittels der Trennschicht (60) im Ruhezustand getrennte leitende Schichten (61, 62), insbesondere zwei Kohleschichten, Schichten mit Leitpaste, metallisierte Schichten und/oder Metallschichten, gestaltete ist, wobei die Display-Einheit (4), insbesondere die berührungssensitive Display-Einheit, unterhalb der Schalterfolie angeordnet ist.

8. Tastenfeld nach einem der Ansprüche 1 bis 7, **dadurch gekennzeichnet, dass** eine elastisch verformbare Schicht (3), insbesondere eine Silikonschicht, vorgesehen ist, wobei die Tastkappen (20) in der elastisch verformbaren Schicht (3) eingebettet sind und aus einer Ruhestellung in eine Betätigungsstellung entgegen einwirkender Rückstellkräfte der elastisch verformbaren Schicht (3) verstellbar sind.

9. Tastenfeld nach Anspruch 8, **dadurch gekennzeichnet, dass** unbelegte Bereiche der Display-Oberfläche (40) durch die elastisch verformbare Schicht (3) maskiert sind, wobei insbesondere die elastisch verformbare Schicht (3) zumindest halbopak, insbesondere opak ist.

10. Tastenfeld nach einem der Ansprüche 1 bis 9, **dadurch gekennzeichnet, dass** die Berührung einer Tastkappe (20) der Mehrzahl an Tasten und/oder ein Krafteintrag an einer Tastkappe (20) der Mehrzahl an Tasten mit einem menschlichen Finger oder einem Eingabeelement mittels des ersten berührungssensitiven Sensors (5) und/oder mittels des zweiten Sensors (6) lokalisierbar ist.

11. Bedieneinheit für eine mobile Maschine, wie beispielsweise eine Landmaschine, eine Baumaschine, ein Flurförderfahrzeug, umfassend ein Tastenfeld nach einem der Ansprüche 1 bis 10.

12. Verwendung eines Tastenfeld nach einem der Ansprüche 1 bis 10 in einer Bedieneinheit für eine mobile Maschine, wie beispielsweise eine Landmaschine, eine Baumaschine, ein Flurförderfahrzeug.

13. Verwendung eines Tastenfeld nach Anspruch 12, **dadurch gekennzeichnet, dass** eine durch Betätigen der Taste (2) durchzuführende Funktion veränderbar ist und eine der Taste (2) zugeordnete Anzeige an der Display-Einheit (4) an die durchzuführende Funktion angepasst wird.

14. Verwendung eines Tastenfeld nach Anspruch 12 oder 13, **dadurch gekennzeichnet, dass** durch Betätigung eines Wahlschalters (80), insbesondere eines Drehrads oder eines Drehdrückrads, weiter insbesondere eines Leucht-Drehrads oder ein Leucht-Drehdrückrads, der mit der Steuereinrichtung (8) gekoppelt ist, die durch Betätigen der Taste (2) durchzuführende Funktion verändert wird.

## Claims

1. Keypad for an operating unit of a safety application comprising a plurality of keys (2), each having a key cap (20), a first touch-sensitive sensor (5), and a second sensor (6), wherein the first touch-sensitive sensor (5) and the second sensor (6) are arranged in such a way that the key cap (20) of one of the plurality of keys (2) being touched and/or an application of force on this key cap (20) by a human finger or an input element is able to be detected by the first touch-sensitive sensor (5) and by the second sensor (6) simultaneously, wherein the key cap (20) is transparent at least in regions and a display unit is arranged underneath the key caps (20), wherein the display unit (4) has a display surface (40) common to the key caps (20), **characterized in that** a monitoring apparatus (41) is provided, which is configured to detect a display on the display unit (4).

2. Keypad according to Claim 1, **characterized in that** the monitoring apparatus (41) is configured to detect a display on an unoccupied area of the display surface (40).

3. Keypad according to Claim 1 or 2, **characterized in that** a control apparatus (8) is provided, wherein a function to be carried out by actuating the keys (2) is able to be changed, and a display, which is assigned to the key (2), on the display unit (4) is able to be adjusted to the function to be carried out by the control apparatus (6).

4. Keypad according to Claim 3, **characterized in that** a selector switch (80) is provided, in particular a rotary knob or a rotary/push knob, more particularly a luminous rotary knob or a luminous rotary/push knob, wherein the selector switch (80) is coupled to the control apparatus (8) so that the function to be carried out by actuating the keys (2) is able to be changed by actuating the selector switch (80).

5. Keypad according to Claim 2, 3 or 4, **characterized in that** the display, which is assigned to the keys (2), on the display unit (4) is able to be changed according to a menu by the control apparatus (8), wherein in particular the first sensor (5) and/or the second sensor (6) is/are coupled to the control apparatus (8) so that a submenu is able to be called up or closed by actuating one of the keys (2).

6. Keypad according to one of Claims 1 to 5, **characterized in that** the first touch-sensitive sensor (5) and the display unit (4) are designed together as a touch-sensitive display unit, in particular as a resistive touch-sensitive display unit.

7. Keypad according to one of Claims 1 to 6, **characterized in that** the second sensor (6) is designed as a touch-sensitive sensor (6), wherein in particular the second sensor (6) is designed as a switch film comprising a separating layer (60) and two conductive layers (61, 62) separated by the separating layer (60) in the rest state, in particular two carbon layers, layers with conductive paste, metallized layers and/or metal layers, wherein the display unit (4), in particular the touch-sensitive display unit, is arranged underneath the switch film.

8. Keypad according to one of Claims 1 to 7, **characterized in that** an elastically deformable layer (3), in particular a silicone layer, is provided, wherein the key caps (20) are embedded in the elastically deformable layer (3) and are able to be disposed from a rest position to an actuating position counter to acting restoring forces of the elastically deformable layer (3).

9. Keypad according to Claim 8, **characterized in that** unoccupied areas of the display surface (40) are masked by the elastically deformable layer (3), wherein in particular the elastically deformable layer (3) is at least semi-opaque, in particular opaque.

10. Keypad according to one of Claims 1 to 9, **characterized in that** a key cap (20) of the plurality of keys being touched and/or an application of force on a key cap (20) of the plurality of keys by a human finger or an input element is able to be localized by the first touch-sensitive sensor (5) and/or by the second sensor (6).

11. Operating unit for a mobile machine, such as, for example, an agricultural machine, a construction machine, or an industrial truck, comprising a keypad according to one of Claims 1 to 10.

12. Use of a keypad according to one of Claims 1 to 10 in an operating unit for a mobile machine, such as, for example, an agricultural machine, a construction machine, or an industrial truck.

13. Use of a keypad according to Claim 12, **characterized in that** a function to be carried out by actuating the key (2) is able to be changed, and a display, which is assigned to the key (2), on the display unit (4) is adjusted to the function to be carried out.

14. Use of a keypad according to Claim 12 or 13, **characterized in that** the function to be carried out by actuating the key (2) is changed by actuating a selector switch (80), in particular a rotary knob or a rotary/push knob, more particularly a luminous rotary knob or a luminous rotary/push knob, which is coupled to the control apparatus (8).

## Revendications

1. Clavier pour une unité de commande d'une application de sécurité, comprenant une pluralité de touches (2) comportant respectivement un capuchon de touche (20), un premier capteur tactile (5) et un second capteur (6), le premier capteur tactile (5) et le second capteur (6) étant disposés de telle manière qu'un contact du capuchon de touche (20) avec l'une de la pluralité de touches (2) et/ou une application de force sur ce capuchon de touche (20) avec un doigt humain ou un élément d'entrée peut être détecté simultanément au moyen du premier capteur tactile (5) et du second capteur (6), les capuchons (20) étant transparents au moins par zones, et une unité d'affichage étant disposée au-dessous des capuchons (20 40), l'unité d'affichage (4) présentant une surface d'affichage commune aux capuchons (20), **caractérisé en ce qu'**il est prévu un dispositif de surveillance (41) conçu pour détecter un affichage sur l'unité d'affichage (4).

2. Clavier selon la revendication 1, **caractérisé en ce que** le dispositif de surveillance (41) est conçu pour détecter un affichage sur une zone non occupée de la surface (40) de l'écran.

3. Clavier selon la revendication 1 ou 2, **caractérisé en ce qu'**il est prévu un dispositif de commande (8), une fonction à effectuer en actionnant les touches (2) étant modifiable et, à l'aide du dispositif de commande (6), un affichage associé à la touche (2) pouvant être adapté à la fonction à exécuter sur l'unité d'affichage (4).

4. Clavier selon la revendication 3, **caractérisé en ce qu'**il est prévu un sélecteur (80), en particulier une molette rotative ou une molette à pression rotative, en particulier une molette rotative lumineuse ou une molette à pression rotative lumineuse, le sélecteur (80) étant couplé au dispositif de commande (8), de sorte que la fonction à effectuer en actionnant les touches (2) puisse être modifiée par l'actionnement du sélecteur (80).

5. Clavier selon la revendication 2, 3 ou 4, **caractérisé en ce que**, au moyen du dispositif de commande (8), l'affichage associé aux touches (2) sur l'unité d'affichage (4) est modifiable en fonction d'un menu, en particulier le premier capteur (5) et/ou le second capteur (6) étant couplés au dispositif de commande (8), de sorte que l'appel ou la fermeture d'un sous-menu puisse être effectué par l'actionnement de l'une des touches (2).

6. Clavier selon l'une des revendications 1 à 5, **caractérisé en ce que** le premier capteur tactile (5) et l'unité d'affichage (4) sont conçus ensemble sous la forme d'une unité d'affichage tactile, en particulier sous forme d'unité d'affichage tactile résistive.

7. Clavier selon l'une des revendications 1 à 6, **caractérisé en ce que** le second capteur (6) est conçu sous la forme d'un capteur tactile (6), le second capteur (6) étant en particulier un film de commutation comprenant une couche de séparation (60) et deux couches conductrices (61, 62) séparées au repos par la couche de séparation (60), en particulier deux couches de carbone, deux couches de pâte conductrice, deux couches métallisées et/ou deux couches métalliques, l'unité d'affichage (4), en particulier l'unité d'affichage tactile, étant disposée au-dessous du film de commutation.

8. Clavier selon l'une des revendications 1 à 7, **caractérisé en ce qu'**il est prévu une couche élastique déformable (3), en particulier une couche de silicone, les capuchons de touches (20) étant intégrés dans la couche élastique déformable (3) et étant réglables d'une position de repos à une position d'actionnement en s'opposant à des forces de rappel exercées par la couche élastique déformable (3).

9. Clavier selon la revendication 8, **caractérisé en ce que** les zones non occupées de la surface (40) de l'écran sont masquées par la couche élastique déformable (3), la couche élastique déformable (3) étant au moins semi-opaque, en particulier opaque.

10. Clavier selon l'une des revendications 1 à 9, **caractérisé en ce que** le contact d'un capuchon de touche (20) de la pluralité de touches et/ou une application de force sur un capuchon de touche (20) de la pluralité de touches avec un doigt humain ou un élément d'entrée peut être localisé au moyen du premier capteur tactile (5) et/ou au moyen du second capteur (6).

11. Unité de commande pour une machine mobile, telle qu'une machine agricole, une machine de chantier, un chariot de manutention, comprenant un clavier selon l'une des revendications 1 à 10.

12. Utilisation d'un clavier selon l'une des revendications 1 à 10 dans une unité de commande pour une machine mobile, telle qu'une machine agricole, une machine de chantier, un chariot de manutention.

13. Utilisation d'un clavier selon la revendication 12, **caractérisée en ce qu'**une fonction à effectuer en appuyant sur la touche (2) est modifiable et **en ce qu'**un affichage associé à la touche (2) est adapté sur l'unité d'affichage (4) à la fonction à effectuer.

14. Utilisation d'un clavier selon la revendication 12 ou 13, **caractérisée en ce que**, par actionnement d'un sélecteur (80), en particulier d'une molette rotative ou d'une molette à pression rotative, en particulier une molette rotative lumineuse ou une molette à pression rotative lumineuse couplée au dispositif de commande (8), la fonction à effectuer en appuyant sur la touche (2) est modifiée.
